(19) Europäisches Patentamt
European Patent Office
Office européen des brevets

(11) **EP 2 546 990 A1**

(12) **EUROPEAN PATENT APPLICATION**

(43) Date of publication:
**16.01.2013 Bulletin 2013/03**

(51) Int Cl.:
*H03L 7/081* (2006.01)  *G01R 23/10* (2006.01)

(21) Application number: **11182867.9**

(22) Date of filing: **27.09.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **15.07.2011 TW 100125218**

(71) Applicants:
• **Askey Technology (Jiangsu) Ltd.
Economic-Technological Development Area
Wujiang Jiangsu (CN)**

• **Askey Computer Corp.
New Taipei City 235 (TW)**

(72) Inventors:
• **Chou, Ming-Hung
110 Taipei City (TW)**
• **Hsieh, Ching-Feng
108 Taipei City (TW)**

(74) Representative: **Bonvicini, Davide et al
Perani & Partners
Patent
Piazza San Babila, 5
20122 Milano (MI) (IT)**

(54) **Method and system for calibrating frequency**

(57)    A method for calibrating frequency, applicable to calibrating a frequency signal generated by a frequency generating unit of an apparatus at a preset frequency, includes obtaining the cycle number of the clock rate of a frequency signal based on a reference signal and a clock mask synchronous with the frequency signal; obtaining a frequency of the frequency signal based on the cycle number; correcting the frequency according to a plurality of phase shift signals generated based on the reference signal; and minimizing an error of the frequency of the frequency signal by increasing the quantity of the phase shift signals, so as to calibrate the frequency signal generated by the frequency generating unit.

FIG. 1

**Description**

FIELD OF THE INVENTION

The present invention relates to methods and systems for calibrating frequency, and more particularly, to a method and system for calibrating frequency by obtaining quickly and precisely an accurate frequency to be calibrated.

BACKGROUND OF THE INVENTION

Plenty of electronic apparatuses are each equipped with a frequency generating unit for providing a frequency signal to be outputted based on a predetermined frequency. To ensure the accuracy of the frequency signal, the conventional electronic apparatus is connected to an external frequency counter for calibration and verification. The frequency counter is a special instrument designed for calibration and verification. The frequency counter is of a size larger than the electronic apparatus is; as a result, the frequency counter has to carry out calibration and verification at a special place and time and at a low speed.

To enable the frequency counter to measure the frequency signal, a gate duration of the frequency counter is set, and the number of the cycles of the frequency signal within the gate duration is counted. Eventually, the frequency of the frequency signal is calculated, using the quotient of the count value and the gate duration.

However, the cycle number of a frequency signal within a gate duration is seldom an integer, and thus the method is likely to cause an error at the beginning and the end of the gate duration — underestimating or overestimating by a half cycle, for example. In view of this, to measure frequency, it is usually necessary to maximize the gate duration in order to handle as many cycles as possible and thereby reduce errors. However, the aforesaid solution is performed at the cost of a great increase in the testing time. Furthermore, given a relatively small number of cycles for measurement, resolution decreases with the gate duration.

SUMMARY OF THE INVENTION

It is an objective of the present invention to enhance the speed and accuracy of frequency measurement.

Another objective of the present invention is to provide an automatic program-controlled method and system for calibrating frequency.

Yet another objective of the present invention is to enable an electronic apparatus to be capable of self-calibration.

In order to achieve the above and other objectives, the present invention provides a method for calibrating frequency, for calibrating a frequency signal generated by a frequency generating unit of an apparatus based on a predetermined frequency, the method comprising the steps of: providing a reference signal; generating a plurality of phase shift signals of a same frequency based on the reference signal, the phase shift signals being spaced apart from each other by a fixed phase; setting a clock mask, the clock mask starting from a first triggering state of the frequency signal and ending at another first triggering state of the frequency signal; counting a number $Nd1$ of second triggering states occurring to the phase shift signals during a time period from a point in time of commencement of the clock mask to occurrence of a first triggering state to the reference signal; counting a number $Nb$ of cycles of the reference signal based on the first triggering state within a time period of the clock mask; counting a number $Ni$ of cycles of the frequency signal based on the first triggering state within a time period of the clock mask; counting a number $Nd2$ of second triggering states occurring to the phase shift signals during a time period from a point in time of termination of the clock mask to occurrence of the first triggering state to the reference signal; and obtaining a frequency $Fi$ of the frequency signal by the equation below: $Fi = \{Ni/[Nb + (Nd/M)]\} \times Fb$; and adjusting an output of the frequency generating unit based on a difference between the predetermined frequency and the frequency $Fi$ of the frequency signal, such that an actual frequency of the frequency signal generated by the frequency generating unit matches the predetermined frequency, wherein $Fb$ denotes a frequency of the reference signal, $Fb > Fi$, $Nd = (Nd1 - Nd2)$, and $M$ said phase shift signals are generated, $M \geqq 2$.

In order to achieve the above and other objectives, the present invention further provides a system for calibrating frequency, adapted for calibrating a frequency signal generated at a predetermined frequency by a frequency generating unit of an apparatus, the system comprising: a frequency signal input end connected to the frequency generating unit for receiving the frequency signal; a count generator connected to the frequency signal input end for receiving the frequency signal, generating a reference signal of a frequency $Fb$, generating $M$ phase shift signals of a same frequency based on the reference signal, the phase shift signals being spaced apart from each other by a fixed phase, generating a clock mask starting from a first triggering state of the frequency signal and ending at another first triggering state of the frequency signal, counting a number $Nd1$ of second triggering states occurring to the phase shift signals during a time period from a point in time of commencement of the clock mask to occurrence of a first triggering state to the reference signal, counting a number Nb of the first triggering states occurring to the reference signal during a time period of the clock mask, counting a number Ni of the first triggering states occurring to the frequency signal during a time period of the clock mask, counting a number Nd2 of the second triggering states occurring to the phase shift signals during a time period from a point in time of termination of the clock mask to occurrence of the first triggering state to the reference signal, and obtaining the values Fb, M, Nb, Ni, Nd1, and Nd2; a computing device connected to the count generator for receiving the values and performing computation by the equation below to obtain a frequency Fi of the frequency signal, wherein $Fi = \{Ni/[Nb + (Nd/M)]\} \times Fb$; and a frequency correcting unit connected to the computing device and the frequency generating unit for adjusting an output of the frequency generating unit based on a difference between the predetermined frequency and the frequency Fi of the frequency signal, such that the frequency of the frequency signal generated by the frequency generating unit matches the predetermined frequency, wherein $Fb > Fi$, and $Nd = (Nd1 - Nd2)$, and $M \geqq 2$.

In an embodiment, the count generator comprises: a fundamental frequency generating unit for generating a fundamental frequency signal; a frequency multiplying unit connected to the fundamental frequency generating unit for turning the fundamental frequency signal into the reference signal by frequency multiplication; and a programmable gate array connected to the frequency signal input end for receiving the frequency signal, connected to the frequency multiplying unit for receiving the reference signal, and adapted for generating the values M, Nb, Ni, Nd1, and Nd2 and outputting the values Fb, M, Nb, Ni, Nd1, and Nd2.

In an embodiment, the computing device is one of a control unit and a computer device.

In an embodiment, the first triggering state is one of a rising edge triggering state and a falling edge triggering state.

In an embodiment, the second triggering state is one of a rising edge triggering state and a falling edge triggering state.

In an embodiment, a number Ni of cycles of the frequency signal occur during a time period of the clock mask, with $Ni \geqq 2$.

In an embodiment, four or eight said phase shift signals are generated.

In an embodiment, the reference signal frequency Fb is directly replaced by a default value.

Accordingly, the present invention provides a method and system for calibrating frequency to eliminate measurement errors by quick and precise multiphase processing, multiply the accuracy of measurement in accordance with the quantity of generated phase shift signals, effectuate fully automatic program-based control by means of synchronous triggering, reduce the area occupied by a circuit, and achieve the objective of frequency calibration by a relatively small circuit area without employing a conventional frequency counter.

BRIEF DESCRIPTION OF THE DRAWINGS

Objectives, features, and advantages of the present invention are hereunder illustrated with specific embodiments in conjunction with the accompanying drawings, in which:

FIG 1 is a timing diagram of a method for measuring an actual frequency of a frequency signal in a method for calibrating frequency according to an embodiment of the present invention;
FIG 2 is a flow chart of the method for calibrating frequency according to an embodiment of the present invention; and
FIG 3 is a function block diagram of a system for calibrating frequency according to an embodiment of the present invention.

DETAILED DESCRIPTION OF THE PREFERRED EMBODIMENTS

The steps of a method for calibrating frequency of the present invention are described in specific embodiments thereof and are, unless otherwise specified, interchangeable in terms of sequence. Furthermore, the concept of "connection" used in the description of specific embodiments of a system for calibrating frequency according to the present invention is not limited to direction connection; instead, connection can also be effectuated by an intervening element. Also, a "first triggering state" and a "second triggering state" used in the description of the method and system for calibrating frequency of the present invention comprise one of a rising edge triggering state and a falling edge triggering state. The first triggering state and the second triggering state are not mutually exclusive; hence, both the first triggering state and the second triggering state may be rising edge triggering states or falling edge triggering states.

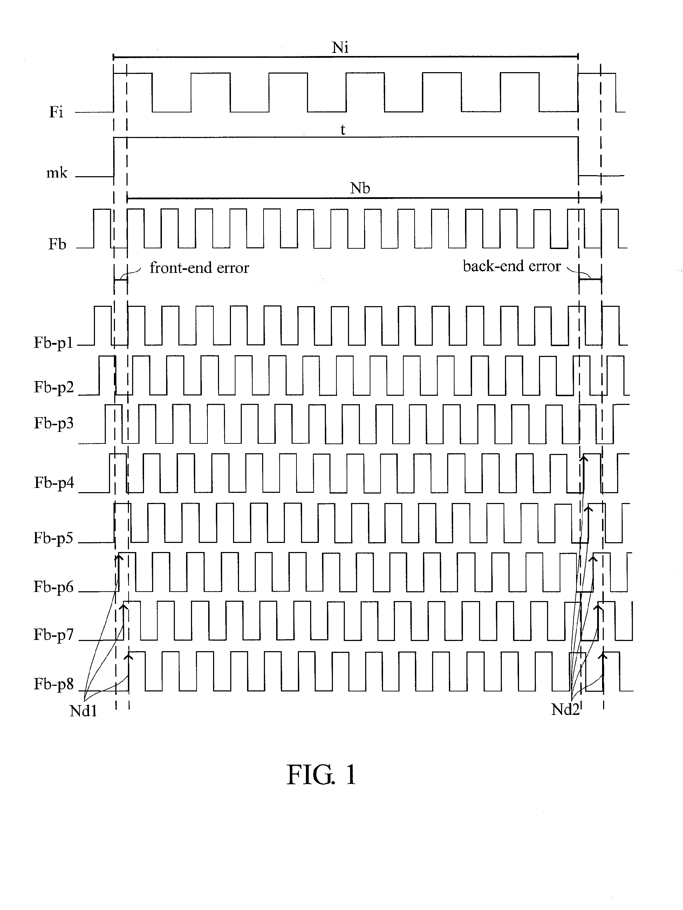

Referring to FIG 1, there is shown a timing diagram of a method for calibrating frequency according to an embodiment of the present invention. As shown in FIG 1, this embodiment is exemplified by eight phase shift signals. Persons skilled in the art should be able to understand that, given at least two phase shift signals, the method and system for calibrating frequency of the present invention is effective in eliminating errors of measurement and thereby enhancing the accuracy thereof.

In an embodiment of the present invention, the method for calibrating frequency is used in calibrating a frequency signal generated by a frequency generating unit of an apparatus based on a predetermined frequency, and the measurement of the frequency signal takes place in two stages, which comprising the steps described hereunder.

As shown in FIG 1, in addition to a frequency signal Fi which has been inputted, measurement is preceded by or starts synchronously with the step of providing a reference signal Fb and the step of generating multilevel phase shift signals Fb-p1~Fb-p8 of the same frequency based on the reference signal, wherein the phase shift signals Fb-p1~Fb-p8 are spaced apart from each other by a fixed phase.

The reference signal Fb functions as a fundamental frequency for calculating the frequency of a frequency signal. The phase shift signals are generated from the reference signal Fb. Normally, the phase shift of a signal is effectuated by a digital clock manager (DCM) of a programmable gate array (FPGA). In this embodiment, eight phase shift signals Fb-p1~Fb-p8 are processed by two digital clock managers, and the reference signal Fb is decomposed by a digital clock manager to form four phase shift signals. However, persons skilled in the art should be able to understand that a user can still selectively shut down four of the phase shift decomposition processes even with just one digital clock manager. Hence, with only one digital clock manager, it is still possible to decompose the reference signal Fb into two or three phase shift signals. Hence, users can select the quantity of required phase shift signals as needed and as appropriate for operation of a digital clock manager. Regarding the spacing of phase shift signals, a digital clock manager divides 360° into equal phase portions and distributes the equal phase portions among the phase shift signals. For example, the phase equals 360°/(M - 1), where M denotes the number of phase shift signals.

Afterward, a clock mask mk is set. The clock mask mk thus set starts from a first triggering state of the frequency signal Fi and ends at another first triggering state of the frequency signal Fi. In this embodiment, the first triggering state is exemplified by a rising edge triggering state. Hence, the clock mask mk can be synchronized with the frequency signal Fi and thus is triggered synchronously in a specific rising edge triggering state of the frequency signal Fi. The clock mask mk maintains a high level unless and until a preset number of cycles of the frequency signal Fi has occurred. Hence, the clock mask mk ends at another first triggering state of the frequency signal Fi. In the embodiment illustrated with FIG 1, the clock mask mk ends at the seventh first triggering state of the frequency signal Fi, and thus six cycles of the frequency signal Fi have passed, that is, the number Ni of cycles of the frequency signal Fi equals 6, or Ni = (the number of instances in which the frequency signal Fi enters the first triggering state) - 1. The number Ni of cycles of the frequency signal Fi must be at least 1 and is preferably at least 2.

Upon initialization of the clock mask mk, measurement kicks off. Referring to FIG 1, the reference signal Fb does not necessarily synchronize with the frequency signal Fi; hence, the time actually taken to effect the number Nb of cycles of the reference signal Fb measured does not fall within the time period of the clock mask mk, thereby resulting in front-end errors and back-end errors. It is because, unlike the frequency signal Fi, the number Nb of cycles of the reference signal Fb measured is usually counted according to the number of rising edge triggering states or falling edge triggering states.

Nb denotes the number of cycles of the reference signal Fb measured within the time period of the clock mask mk and based on the first triggering state. Ni denotes the number of cycles of the frequency signal Fi measured within the time period of the clock mask mk and based on the first triggering state. The feature "being based on the first triggering state" means that the counting of the number of cycles of the reference signal Fb is in line with the point in time of termination of the front-end error time period. Hence, as shown in FIG 1, the point in time of commencement of the counting of the number of cycles of the reference signal Fb starts from the rising edge triggering state rather than the falling edge triggering state. Conversely, if the front-end error time period is changed to a time period starting from the point in time of commencement of the clock mask mk and ending at the point in time of occurrence of a falling edge triggering state (first triggering state) to the reference signal Fb, the front-end error time period will end at the falling edge triggering state, and the point in time of commencement of the counting of the number of cycles of the reference signal Fb will start from the falling edge triggering state.

Hence, in the embodiments of the present invention, the front-end errors and back-end errors are eliminated by the phase shift signals. The front-end errors and back-end errors are hereunder illustrated with signal timing.

Regarding the front-end errors, the number Nd1 of second triggering states (rising or falling triggering states) that occur to the phase shift signals Fb-p1~Fb-p8 during the time period from the point in time of commencement of the clock mask mk to the point in time when a first triggering state occurs to the reference signal Fb is counted.

Regarding the back-end errors, the number Nd2 of second triggering states (rising or falling triggering states) that occur to the phase shift signals Fb-p1~Fb-p8 during the time period from the point in time of termination of the clock mask mk to the point in time when a first triggering state occurs to the reference signal Fb is counted.

Counting the second triggering states that occur to the phase shift signals Fb-p1~Fb-p8 means that elimination of back-end errors requires selecting the rising edge triggering state as the second triggering state when elimination of front-end errors requires selecting the rising edge triggering state as the second triggering state, or means that elimination of back-end errors requires selecting the falling edge triggering state as the second triggering state when elimination of front-end errors requires selecting the falling edge triggering state as the second triggering state. As shown in FIG 1, the rising edge triggering state is selected to be the second triggering state, thereby setting Nd1 to 3 and Nd2 to 5 as shown in FIG 1.

In a subsequent calculation process, the number Nd2 is subtracted from the number Nd1 to obtain the number of cycles which falls within the time period of the clock mask mk and needs to be calibrated, so as to eliminate front-end and back-end errors.

Upon acquisition of the aforesaid values, the frequency of the frequency signal Fi can be calculated by equation (1) as follows:

$$Fi = \{Ni/[Nb + (Nd/M)]\} \times Fb \qquad (1)$$

wherein Nd denotes a calibration value, Nd = (Nd1 - Nd2), and M denotes the number of the phase shift signals, with $M \geqq 2$, indicating that at least two said phase shift signals are generated.

The extent of the enhancement of measurement accuracy by the method according to an embodiment of the present invention is described below. Basically, the frequency of the frequency signal Fi is calculated by equation (2) as follows:

$$(Ni/Fi) = (Nb/Fb) \qquad (2)$$

equation (2) can also be rewritten as:

$$Fi \fallingdotseq (Ni/Nb) \times Fb \qquad (3)$$

The precondition to satisfaction of equation (3) is that the frequency of the reference signal Fb must be larger than the frequency of the frequency signal Fi.

However, as revealed above, the frequency of the frequency signal Fi will be inaccurate when calculated by equation (3), if the front-end and back-end errors are not calibrated. Accuracy-enhancing calculation entails eliminating front-end errors and eliminating back-end errors. It is only when the two stages of frequency measurement are done that the time period of clock mask mk can be fully covered. Hence, the extent of the elimination of the front-end and back-end errors depends on the result of computation based on the calibration value Nd. Furthermore, as indicated by equation (1), the multiplicative increment in accuracy increases with the quantity of the phase shift signals. Hence, the method of the embodiments of the present invention achieves an at least eightfold increase in accuracy, when compared with a conventional method for calibrating frequency wherein front-end errors and back-end errors are not calibrated.

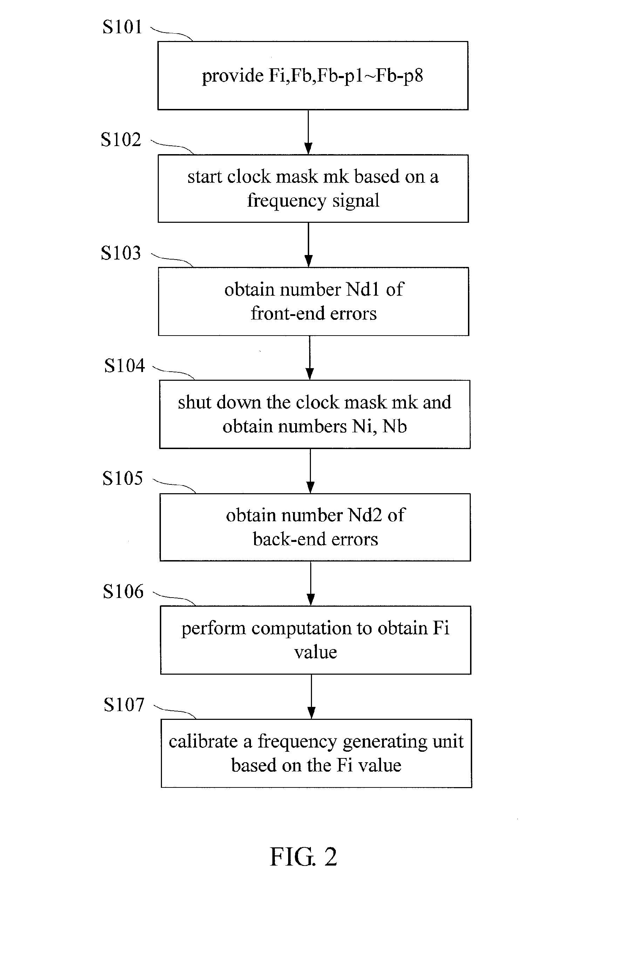

Referring to FIG 2 and FIG 1, there is shown in FIG 2 a flow chart of the method for calibrating frequency according to timing in an embodiment of the present invention. As shown in FIG 2, step S101 involves providing the frequency signal Fi, the reference signal Fb, and the plurality of phase shift signals Fb-p1~Fb-p8. Step S102 involves starting the clock mask mk synchronously with the frequency signal Fi. Step S103 involves obtaining the count number Nd1 of front-end errors. Step S104 involves shutting down the clock mask mk and obtaining the numbers Ni, Nb of cycles of the frequency signal Fi and the reference signal Fb, respectively. Step S105 involves obtaining the count number Nd2 of back-end errors. Step S106 involves performing computation by equation (1) to obtain the value Fi. Finally, in step S107, the frequency correcting unit adjusts the output of the frequency generating unit based on the difference between the predetermined frequency and the frequency Fi of the frequency signal, such that the actual frequency of the frequency signal generated by the frequency generating unit matches the predetermined frequency, for example, adjusting them until they equal each other or differ from each other by a predetermined range.

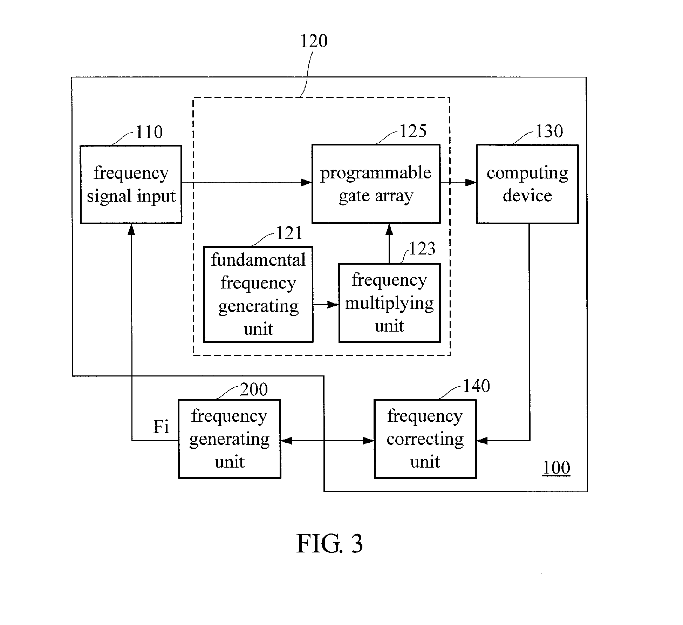

Referring to FIG 3, there is shown a function block diagram of a system 100 for calibrating frequency according to an embodiment of the present invention. As shown in FIG 3, the frequency calibrating system 100 comprises a frequency signal input end 110, a count generator 120, a computing device 130, and a frequency correcting unit 140, and is adapted to calibrate a frequency signal generated at a predetermined frequency by a frequency generating unit 200 in an apparatus.

The frequency signal input end 110 is connected to the frequency generating unit 200 for receiving the frequency signal Fi.

The count generator 120 is connected to the frequency signal input end 110 for receiving the frequency signal Fi. The count generator 120 generates the reference signal Fb, M phase shift signals which are spaced apart from each other by a fixed phase, the clock mask mk, the number Nd1 of second triggering states occurring to the phase shift signals during a front-end error time period, the number Nb of first triggering states occurring to the reference signal Fb during the time period of the clock mask mk, the number Ni of the first triggering states occurring to the frequency signal Fi during the time period of the clock mask mk, and the number Nd2 of the second triggering states occurring to the phase shift signals during a back-end error time period, and outputs the values Fb, M, Nb, Ni, Nd1, and Nd2.

In an embodiment, the count generator 120 comprises a fundamental frequency generating unit 121, a frequency multiplying unit 123, and a programmable gate array 125. The fundamental frequency generating unit 121 generates a fundamental frequency signal. Normally, a low fundamental frequency is generated by a crystal oscillator to cut costs, and then the fundamental frequency is boosted by a frequency multiplying unit 123 connected to the fundamental frequency generating unit 121 for functioning as the reference signal Fb. The fundamental frequency is usually increased to go beyond the possible frequency range of the frequency signal Fi. Hence, different frequency signals correspond to their respective frequencies of the reference signal Fb. Of course, the higher the frequency of the reference signal Fb is, the wider its application is. The programmable gate array 125 comprises: a digital clock manager for functioning as a phase shift generating circuit; a differential circuit for performing rising or falling differentiation (rising edge triggering or falling edge triggering) to count the numbers Nd1 and Nd2; and a mask circuit for generating the clock mask mk and counting the frequency signal Fi and the reference signal Fb. Accordingly, the programmable gate array 125 generates the values M, Nb, Ni, Nd1, and Nd2 and outputs the values Fb, M, Nb, Ni, Nd1, and Nd2.

The programmable gate array 125 is a conventional element. The measuring system according to an embodiment of the present invention achieves the objectives of the present invention by means of logical elements. The method according to an embodiment of the present invention reduces the required number of the logical elements, dispenses with a large-sized programmable gate array chip, and thus reduces the circuit-occupied area and downsizes the product. For example, if the computing function of a computing device is also incorporated into the programmable gate array, the required number of the logical elements will be greatly increased, thereby increasing the circuit-occupied area. Due to its structural design, it is necessary for the programmable gate array to perform computation by logic, and thus the computation is rapid; however, the required logical elements are bulky. Although a special programmable gate array having a computation structure circuit disposed therein has low logical element spatial requirements and can perform high-speed computation, it incurs an excessively high cost.

The computing device 130 is connected to the count generator 120 for receiving the values and performing computation by equation (1) to obtain the frequency of the frequency signal Fi. The computing device 130 is a control unit (MCU) or a computer device. If the computing device 130 is a control unit, then the control unit is usually disposed on the same circuit board as the count generator 120 is, such that the frequency calibrating system 100 in its entirety is integrated onto a module and even directly disposed in an apparatus to effect a self-calibration function; however, the computing device 130 can also be an external computer device for processing a computation procedure in whole with data provided by a measuring module.

The frequency correcting unit 140 is connected to the computing device 130 and the frequency generating unit 200 for adjusting the output of the frequency generating unit 200 based on the difference between the predetermined frequency and the frequency Fi of the frequency signal, such that the frequency of the frequency signal generated by the frequency generating unit 200 matches the predetermined frequency.

To reduce errors further, it is feasible to perform a high-precision measurement process on the generated reference signal Fb beforehand. To preclude any error which might otherwise be produced as a result of a discrepancy between a frequency actually generated by a fundamental frequency generating unit and a frequency multiplier and a given frequency level (that is, a value set forth in the specifications of a fundamental frequency generating unit and a frequency multiplier), it is feasible to measure the reference signal Fb in advance by means of a high-precision frequency counter having a higher resolution than the frequency of the reference signal Fb, and then use the measured reference signal Fb as a default value to be directly stored in the computing device 130. It is even feasible to infer the frequency of the reference signal retrogressively, using a precise frequency signal provided by a signal generating instrument, and then the inferred frequency is treated as the default value and directly stored in the computing device 130. In doing so, in every instance of measurement, the default value always applies to the frequency of the reference signal Fb, thereby dispensing with the need to use a parameter set forth in the specifications of a fundamental frequency generating unit and a frequency multiplier.

In conclusion, a method and system for calibrating frequency of the present invention employs quick and precise multiphase processing to eliminate frequency signal measurement errors which might otherwise occur in a calibration process and multiplies the accuracy of measurement in accordance with the quantity of generated phase shift signals. An embodiment of the present invention achieves eightfold reduction (corresponding to eight phase shift signals) in errors, effectuates fully automatic program-based control by means of synchronous triggering, and reduces the area occupied by a circuit.

The present invention is disclosed above by preferred embodiments. However, persons skilled in the art should understand that the preferred embodiments are illustrative of the present invention only, but should not be interpreted as restrictive of the scope of the present invention. Hence, all equivalent modifications and replacements made to the aforesaid embodiments should fall within the scope of the present invention. Accordingly, the legal protection for the present invention should be defined by the appended claims.

**Claims**

1.  A method for calibrating frequency, for calibrating a frequency signal generated by a frequency generating unit of an apparatus based on a predetermined frequency, the method comprising the steps of:

    providing a reference signal;
    generating a plurality of phase shift signals of a same frequency based on the reference signal, the phase shift signals being spaced apart from each other by a fixed phase;
    setting a clock mask, the clock mask starting from a first triggering state of the frequency signal and ending at another first triggering state of the frequency signal;
    counting a number Nd1 of second triggering states occurring to the phase shift signals during a time period from a point in time of commencement of the clock mask to occurrence of a first triggering state to the reference signal;
    counting a number Nb of cycles of the reference signal based on the first triggering state within a time period of the clock mask;
    counting a number Ni of cycles of the frequency signal based on the first triggering state within a time period of the clock mask;
    counting a number Nd2 of second triggering states occurring to the phase shift signals during a time period from a point in time of termination of the clock mask to occurrence of the first triggering state to the reference signal; and
    obtaining a frequency Fi of the frequency signal by the equation below:

    $Fi = \{Ni/[Nb + (Nd/M)]\} \times Fb$; and
    adjusting an output of the frequency generating unit based on a difference between the predetermined frequency and the frequency Fi of the frequency signal, such that an actual frequency of the frequency signal generated by the frequency generating unit matches the predetermined frequency,
    wherein Fb denotes a frequency of the reference signal, Fb > Fi, Nd = (Nd1 - Nd2), and M said phase shift signals are generated, M≧2.

2.  The method of claim 1, wherein the first triggering state is one of a rising edge triggering state and a falling edge triggering state.

3.  The method of claim 1, wherein the second triggering state is one of a rising edge triggering state and a falling edge triggering state.

4.  The method of claim 1, wherein a number Ni of cycles of the frequency signal occur during a time period of the clock mask, with Ni ≧2.

5.  The method of claim 1, wherein four or eight said phase shift signals are generated.

6.  The method of claim 1, further comprising replacing the reference signal frequency Fb with a default value.

7.  The method of claim 1, wherein the fixed phase equals 360°/(M - 1).

8.  A system for calibrating frequency, adapted for calibrating a frequency signal generated at a predetermined frequency by a frequency generating unit of an apparatus, the system comprising:

    a frequency signal input end connected to the frequency generating unit for receiving the frequency signal;
    a count generator connected to the frequency signal input end for receiving the frequency signal, generating a reference signal of a frequency Fb, generating M phase shift signals of a same frequency based on the reference signal, the phase shift signals being spaced apart from each other by a fixed phase, generating a clock mask starting from a first triggering state of the frequency signal and ending at another first triggering state of the frequency signal, counting a number Nd1 of second triggering states occurring to the phase shift signals during a time period from a point in time of commencement of the clock mask to occurrence of a first triggering state to the reference signal, counting a number Nb of the first triggering states occurring to the reference signal during a time period of the clock mask, counting a number Ni of the first triggering states occurring to the frequency signal during a time period of the clock mask, counting a number Nd2 of the second triggering states occurring to the phase shift signals during a time period from a point in time of termination of the clock mask to occurrence of the first triggering state to the reference signal, and obtaining the values Fb, M, Nb, Ni, Nd1, and Nd2;

a computing device connected to the count generator for receiving the values and performing computation by the equation below to obtain a frequency Fi of the frequency signal, wherein $Fi = \{Ni/[Nb + (Nd/M)]\} \times Fb$; and

a frequency correcting unit connected to the computing device and the frequency generating unit for adjusting an output of the frequency generating unit based on a difference between the predetermined frequency and the frequency Fi of the frequency signal, such that the frequency of the frequency signal generated by the frequency generating unit matches the predetermined frequency,

wherein $Fb > Fi$, and $Nd = (Nd1 - Nd2)$, and $M \geqq 2$.

9. The system of claim 8, wherein the count generator comprises:

a fundamental frequency generating unit for generating a fundamental frequency signal;

a frequency multiplying unit connected to the fundamental frequency generating unit for turning the fundamental frequency signal into the reference signal by frequency multiplication; and

a programmable gate array connected to the frequency signal input end for receiving the frequency signal, connected to the frequency multiplying unit for receiving the reference signal, and adapted for generating the values M, Nb, Ni, Nd1, and Nd2 and outputting the values Fb, M, Nb, Ni, Nd1, and Nd2.

10. The system of claim 9, wherein the computing device replaces the value Fb with a default value.

11. The system of claim 8, wherein the computing device is one of a control unit and a computer device.

12. The system of claim 8, wherein the first triggering state is one of a rising edge triggering state and a falling edge triggering state, and the second triggering state is one of a rising edge triggering state and a falling edge triggering state.

FIG. 1

S101

provide Fi,Fb,Fb-p1~Fb-p8

S102

start clock mask mk based on a
frequency signal

S103

obtain number Nd1 of
front-end errors

S104

shut down the clock mask mk and
obtain numbers Ni, Nb

S105

obtain number Nd2 of
back-end errors

S106

perform computation to obtain Fi
value

S107

calibrate a frequency generating unit
based on the Fi value

FIG. 2

120

110

frequency
signal input

125

programmable
gate array

130

computing
device

121

fundamental
frequency
generating
unit

123

frequency
multiplying
unit

200

Fi

frequency
generating
unit

140

frequency
correcting
unit

100

FIG. 3

Europäisches
Patentamt

European
Patent Office

Office européen
des brevets

## EUROPEAN SEARCH REPORT

Application Number

EP 11 18 2867

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 4 541 009 A (ROUGEOLLE DANIEL [FR] ET AL) 10 September 1985 (1985-09-10) * column 2, line 28 - column 3, line 20; figures 3,4 * ----- | 1-12 | INV. H03L7/081 G01R23/10 |
| A | US 4 786 861 A (HULSING II RAND H [US] ET AL) 22 November 1988 (1988-11-22) * abstract; figure 3 * ----- | 1-12 | |
| A | WO 92/04634 A1 (SUNDSTRAND DATA CONTROL [US]) 19 March 1992 (1992-03-19) * the whole document * ----- | 1-12 | |
| A | EP 1 227 591 A1 (FUJITSU LTD [JP]) 31 July 2002 (2002-07-31) * paragraph [0022] - paragraph [0026]; figure 1 * ----- | 1-12 | |

TECHNICAL FIELDS SEARCHED (IPC)

H03L
G01R
H04L
H03K

The present search report has been drawn up for all claims

| Place of search | Date of completion of the search | Examiner |
|---|---|---|
| The Hague | 21 November 2012 | Beasley-Suffolk, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 11 18 2867

This annex lists the patent family members relating to the patent documents cited in the above-mentioned European search report.
The members are as contained in the European Patent Office EDP file on
The European Patent Office is in no way liable for these particulars which are merely given for the purpose of information.

21-11-2012

| Patent document cited in search report | | Publication date | Patent family member(s) | | Publication date |
|---|---|---|---|---|---|
| US 4541009 | A | 10-09-1985 | CA | 1202420 A1 | 25-03-1986 |
| | | | DE | 3266812 D1 | 14-11-1985 |
| | | | EP | 0071505 A1 | 09-02-1983 |
| | | | FR | 2510330 A1 | 28-01-1983 |
| | | | JP | 58025715 A | 16-02-1983 |
| | | | US | 4541009 A | 10-09-1985 |
| US 4786861 | A | 22-11-1988 | CA | 1278041 C | 18-12-1990 |
| | | | EP | 0330693 A1 | 06-09-1989 |
| | | | JP | H01502933 A | 05-10-1989 |
| | | | US | 4786861 A | 22-11-1988 |
| | | | WO | 8902080 A1 | 09-03-1989 |
| WO 9204634 | A1 | 19-03-1992 | CA | 2091349 A1 | 13-03-1992 |
| | | | DE | 69123592 D1 | 23-01-1997 |
| | | | EP | 0548253 A1 | 30-06-1993 |
| | | | JP | 3591835 B2 | 24-11-2004 |
| | | | JP | H06501554 A | 17-02-1994 |
| | | | US | 5095264 A | 10-03-1992 |
| | | | WO | 9204634 A1 | 19-03-1992 |
| EP 1227591 | A1 | 31-07-2002 | CN | 1379929 A | 13-11-2002 |
| | | | DE | 60025732 T2 | 20-07-2006 |
| | | | EP | 1227591 A1 | 31-07-2002 |
| | | | JP | 3691310 B2 | 07-09-2005 |
| | | | JP | 2001119291 A | 27-04-2001 |
| | | | US | 6674277 B1 | 06-01-2004 |
| | | | US | 2004100245 A1 | 27-05-2004 |
| | | | WO | 0129969 A1 | 26-04-2001 |

EPO FORM P0459

For more details about this annex : see Official Journal of the European Patent Office, No. 12/82